# EUROPEAN PATENT APPLICATION

(11) **EP 4 831 343 A1**
(43) Date of publication of application: **28.10.2026**
(21) Application number: 24908112.6
(22) Date of filing: 19.12.2024
(51) Int. Cl.: C23C 16/40, C07F 5/00, C23C 16/455

(54) **NOVEL COMPOUND, PRECURSOR COMPOSITION COMPRISING SAME, AND METHOD FOR MANUFACTURING THIN FILM USING SAME**

(30) Priority: 19.12.2023 KR 20230185358
(71) Applicant: Hansol Chemical Co., Ltd, Seoul 06169 (KR)
(72) Inventor: YEOM, Kyu-Hyun, Wanju-gun, Jeonbuk-do 55321 (KR); MUN, Ki-Yeung, Wanju-gun, Jeonbuk-do 55321 (KR); RYU, Dae-Won, Wanju-gun, Jeonbuk-do 55321 (KR); SEOK, Jang-Hyeon, Sejong 30151 (KR)
(74) Representative: Cabinet Chaillot
(86) International application number: PCT/KR2024/020705
(87) International publication number: WO 2025/135829

(57) **Abstract**

The present invention relates to a precursor composition for vapor deposition capable of depositing a thin film through vapor deposition and, specifically, to: a novel compound that can be applied to atomic layer deposition (ALD) or chemical vapor deposition (CVD) and has excellent reactivity, volatility, and thermal stability; a precursor composition comprising the novel compound; and a method for manufacturing a thin film using the precursor composition.

## Description

### Technical Field

The present disclosure relates to a novel compound capable of depositing a thin film through vapor deposition, a precursor composition including the novel compound, and a method for manufacturing a thin film using the precursor composition.

### Background Art

As semiconductor devices are becoming more highly integrated and more miniaturized, forming metal and metal oxide thin films having uniform thickness for application to various technologies, such as microelectronics, magnetic information storage, catalysts, and so on is becoming important.

Chemical Vapor Deposition (CVD) or Atomic Layer Deposition (ALD) is used to manufacture metal and metal oxide thin films. Particularly, Atomic Layer Deposition enables formation of a desired thin film by sequentially injecting and removing reactants into and from a chamber, facilitates control of composition, and enables formation of a thin film having uniform thickness. In addition, Atomic Layer Deposition has an advantage of having excellent step coverage and thus being capable of uniformly growing a thin film on a complex and precise device.

In order to manufacture a thin film by Atomic Layer Deposition, a precursor plays an important role, and properties such as high volatility, high thermal stability, high reactivity in a chamber, and so on are required. To date, development of precursors has been conducted by applying various ligands, and representative known ligands include halogens, alkoxides, cyclopentadienes, beta-diketonates, amides, amidinates, and so on. However, most known precursors are solid compounds, or have low volatility or low stability, or may cause problems such as impurity contamination during thin film deposition. Therefore, development of a novel precursor having excellent characteristics in which the above-described disadvantages are removed is required.

Particularly, silicon dioxide (SiO₂) has been used as a gate dielectric material of a transistor to date. However, as sizes of semiconductor devices have recently become increasingly smaller, problems of tunneling current leakage, a corresponding increase in power dissipation, and generation of heat have become serious. Accordingly, the necessity of developing a new material having high dielectric constant to replace a SiO₂ dielectric has emerged, and research on oxide semiconductors as promising candidates has been actively conducted.

Indium gallium oxide (IGO) is a ternary n-type oxide semiconductor, has good channel mobility and excellent light transmittance, and thus can be very usefully used for a transparent thin film transistor (TFT). In addition, indium gallium oxide exhibits a two-orders-of-magnitude change in resistance value between an amorphous structure exhibiting a high resistance value and a cubic structure exhibiting a low resistance value. Due to these characteristics, indium gallium oxide is considered a material suitable for a Phase Change Memory (PCM) device capable of being driven with low power.

### [Document of Related Art]

### [Patent Document]

(Patent Document 1) Korean Patent Application Publication No. 10-2023-0074580

### Disclosure

### Technical Problem

The present disclosure is intended to provide a novel compound applicable to Atomic Layer Deposition (ALD) or Chemical Vapor Deposition (CVD), and a precursor composition including the novel compound.

Particularly, an objective of the present disclosure is to provide a precursor composition that is liquid, has excellent thermal stability and volatility, has excellent ALD characteristics, enables deposition of a thin film in which impurities are hardly present and which has excellent step coverage, and enables uniform thin film deposition in a wide temperature range.

In addition, the present disclosure is intended to provide a method for manufacturing a thin film using the precursor composition.

However, objectives to be solved by the present disclosure are not limited to the above-described objectives, and other objectives not mentioned above may be clearly understood by a person having ordinary skill in the art from the following description.

### Technical Solution

According to an aspect of the present disclosure, there is provided a composition including a first compound represented by Chemical Formula 1 described below and a second compound represented by Chemical Formula 2 described below:

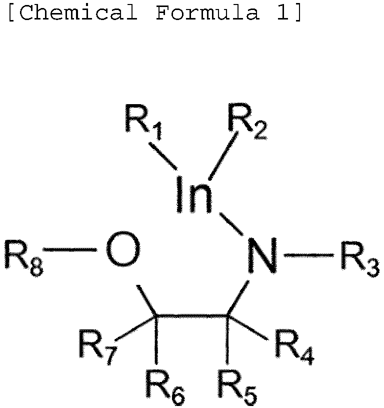

In Chemical Formula 1,
R₁ and R₂ are each independently hydrogen, a linear or branched hydrocarbon group having 1 to 4 carbon atoms, OR₉, or NR₁₀R₁₁,
R₃ and R₈ are each independently hydrogen or a linear or branched hydrocarbon group having 1 to 6 carbon atoms,
R₄ to R₇ are each independently hydrogen or a linear or branched hydrocarbon group having 1 to 3 carbon atoms, and
R₉ to R₁₁ are each independently hydrogen or a linear or branched hydrocarbon group having 1 to 3 carbon atoms, and

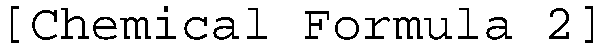

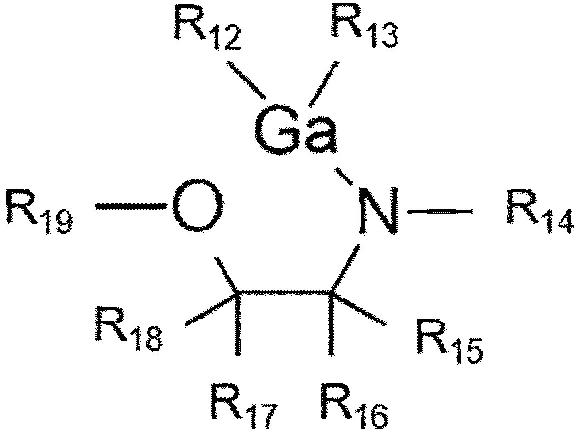

In Chemical Formula 2,
R₁₂ and R₁₃ are each independently hydrogen, a linear or branched hydrocarbon group having 1 to 4 carbon atoms, OR₂₀, or NR₂₁R₂₂,
R₁₄ and R₁₉ are each independently hydrogen or a linear or branched hydrocarbon group having 1 to 6 carbon atoms,
R₁₅ to R₁₈ are each independently hydrogen or a linear or branched hydrocarbon group having 1 to 3 carbon atoms, and
R₂₀ to R₂₂ are each independently hydrogen or a linear or branched hydrocarbon group having 1 to 3 carbon atoms.

According to another aspect of the present disclosure, there is provided a precursor composition for vapor deposition, the precursor composition including the composition.

According to still another aspect of the present disclosure, there is provided a method for manufacturing a thin film, the method including introducing the precursor composition for vapor deposition into a chamber.

According to still yet another aspect of the present disclosure, there is provided a thin film manufactured by the method for manufacturing the thin film.

### Advantageous Effects

The composition according to the present disclosure is liquid, has excellent ALD characteristics, enables uniform thin film deposition, and accordingly enables securing of a thin film in which impurities are hardly present and which has excellent step coverage characteristics.

The above-described physical properties provide a precursor suitable for Atomic Layer Deposition and Chemical Vapor Deposition.

In addition, a thin film deposited using the composition of the present disclosure is expected to be utilized as an active layer of an oxide thin film transistor (TFT) in a display device in the future, and may be used as a channel or the like in manufacturing a memory semiconductor.

### Description of Drawings

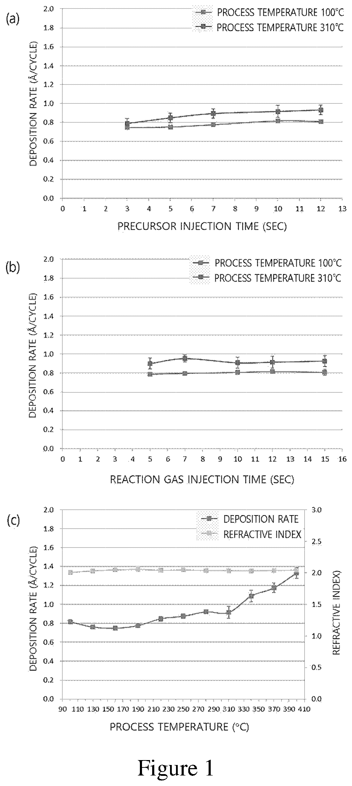

FIG. 1(a) is a graph showing a change in deposition rate according to a change in precursor injection time in manufacturing an indium gallium oxide film of Preparation Example 1 of the present disclosure, FIG. 1(b) is a graph showing a change in deposition rate according to a change in reaction gas injection time in manufacturing an indium gallium oxide film of Preparation Example 2 of the present disclosure, and FIG. 1(c) is a graph showing a change in deposition rate according to a change in process temperature in manufacturing an indium gallium oxide film of Preparation Example 3 of the present disclosure.

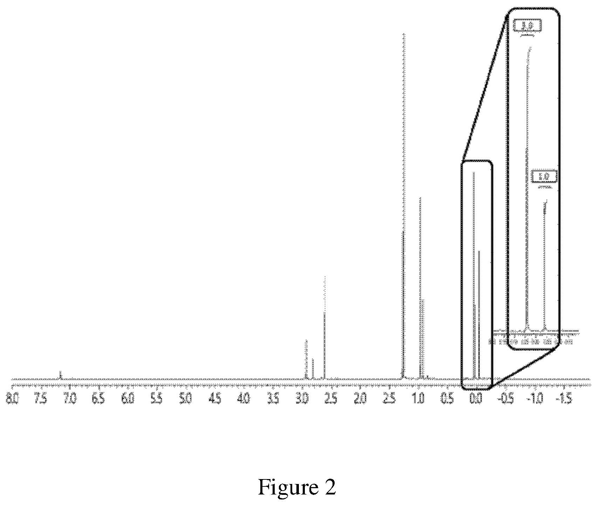

FIG. 2 is a graph showing Nuclear Magnetic Resonance (NMR) measurement results of a composition having a DMION-to-DMGON ratio of 3:1 according to an example of the present disclosure.

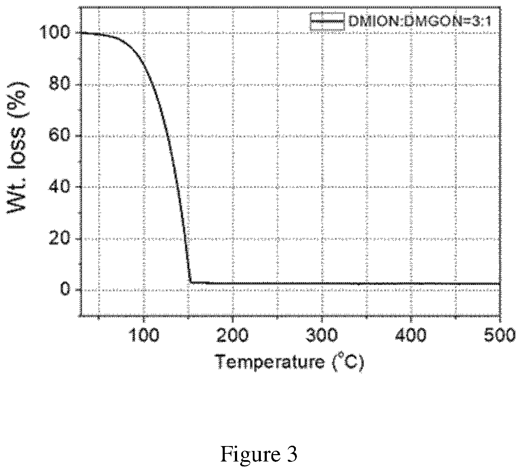

FIG. 3 is a graph showing analysis results according to Thermogravimetric Analysis (TGA) of the composition having the DMION-to-DMGON ratio of 3:1 according to the example of the present disclosure.

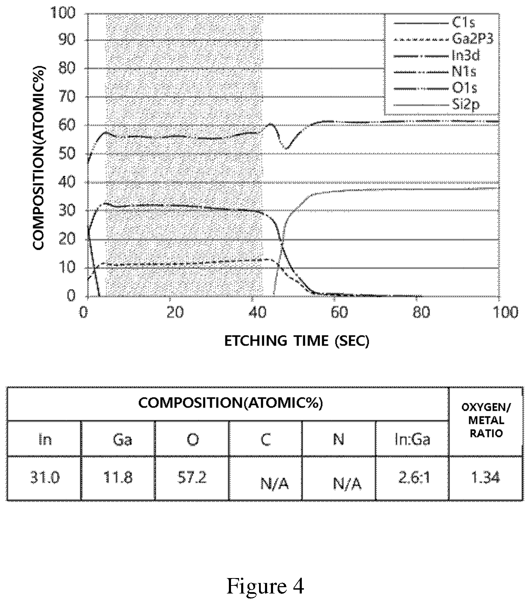

FIG. 4 is a graph and a table showing results acquired by measuring an X-ray photoelectron spectroscopy (XPS) depth profile of an indium gallium oxide film which has a thickness of 20 nm and which is deposited at a process temperature of 310 degrees Celsius.

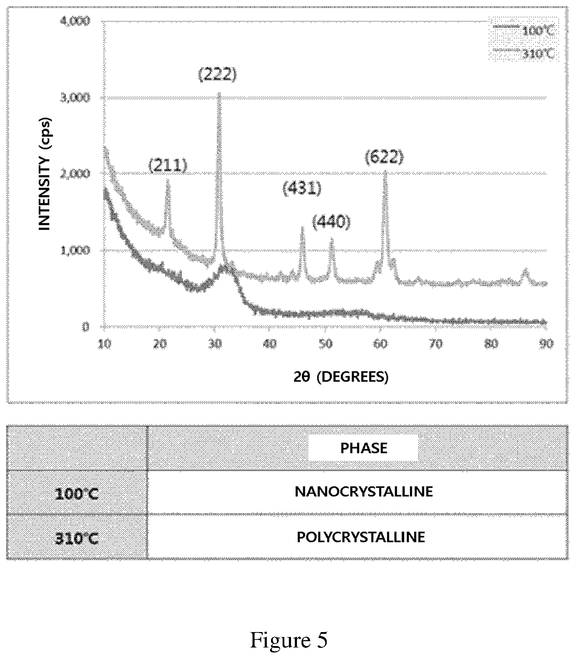

FIG. 5 is a graph and a table showing analysis results according to X-Ray Diffractometry (XRD) of indium gallium oxide films deposited using the composition having the DMION-to-DMGON ratio of 3:1 according to the example of the present disclosure at process temperatures of 100 degrees Celsius and 310 degrees Celsius.

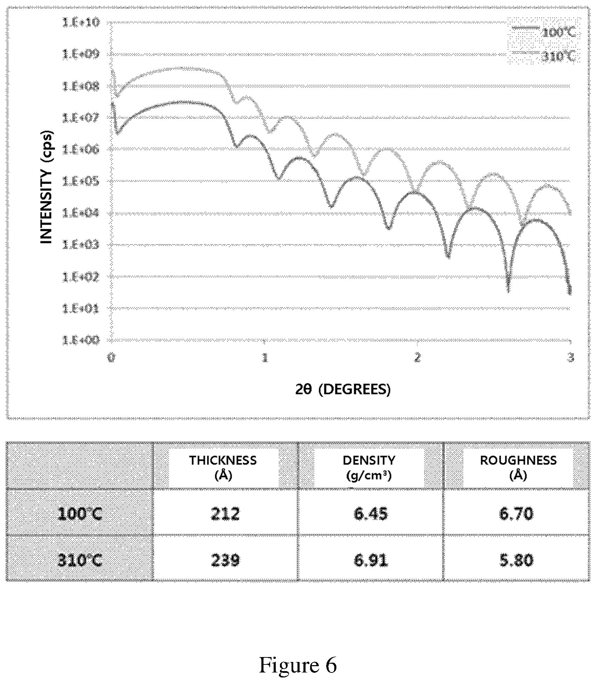

FIG. 6 is a graph and a table showing analysis results according to X-Ray Reflectometry (XRR) of indium gallium oxide films deposited using the composition having the DMION-to-DMGON ratio of 3:1 according to the example of the present disclosure at process temperatures of 100 degrees Celsius and 310 degrees Celsius.

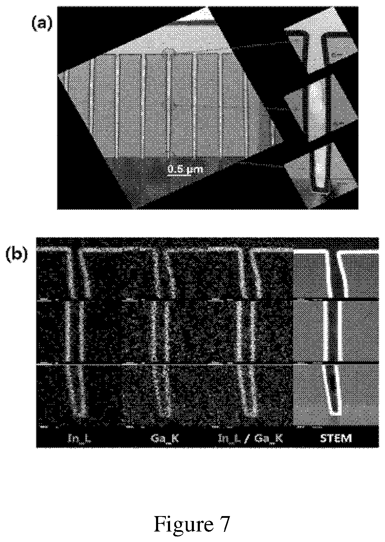

FIG. 7(a) is a photograph acquired by capturing, with Transmission Electron Microscopy (TEM), an indium gallium oxide film deposited at a process temperature of 310 degrees Celsius and manufactured in a trench structure having an aspect ratio of 40:1, and FIG. 7(b) is a photograph showing mapping results acquired through Energy Dispersive X-Ray Spectrometry (EDS) of the indium gallium oxide film.

### Best Mode

Hereinafter, the action and effect of the present disclosure will be described in more detail through specific embodiments of the present disclosure. However, these embodiments are provided only for illustrative purposes of the present disclosure, and the scope of the present disclosure is not limited thereby.

Before discussing the details, it should be noted that all terms or words used herein and used in the appended claims are not construed as being limited to general and dictionary meanings but will be interpreted based on the meanings and concepts corresponding to the technical ideas of the present disclosure, following the principle that any inventor is allowed to define the concepts of terms as appropriate to describe the disclosure thereof in the best mode.

Therefore, the embodiments described herein are configured merely as one of the most preferable examples of the present disclosure and do not exhaustively represent the technical idea of the present disclosure. Accordingly, it should be appreciated that there may be various equivalents and modifications that can replace these embodiments as of the filing date of the present application.

As used herein, the singular forms are intended to include the plural forms, unless the context clearly indicates otherwise. It will be further understood that the terms "comprise," "include," "contain," "have," and so on when used herein, are intended to specify the presence of stated features, integers, steps, constituent elements, or combinations thereof but do not preclude the possibility of the presence or addition of one or more other features, integers, steps, constituent elements, or combinations thereof.

In the present specification, in expressions indicating a numerical range such as "a to b" and "a ~ b", "to" and "~" are defined as equal to or larger than a (≥ a) and equal to or less than b (≤ b).

A composition according to an aspect of the present disclosure may include a first compound represented by the following Chemical Formula 1 and a second compound represented by the following Chemical Formula 2.

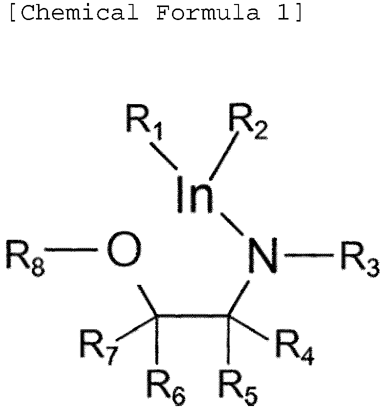

In Chemical Formula 1,
R₁ and R₂ are each independently hydrogen, a linear or branched hydrocarbon group having 1 to 4 carbon atoms, OR₉, or NR₁₀R₁₁,
R₃ and R₈ are each independently hydrogen or a linear or branched hydrocarbon group having 1 to 6 carbon atoms,
R₄ to R₇ are each independently hydrogen or a linear or branched hydrocarbon group having 1 to 3 carbon atoms, and
R₉ to R₁₁ are each independently hydrogen or a linear or branched hydrocarbon group having 1 to 3 carbon atoms.

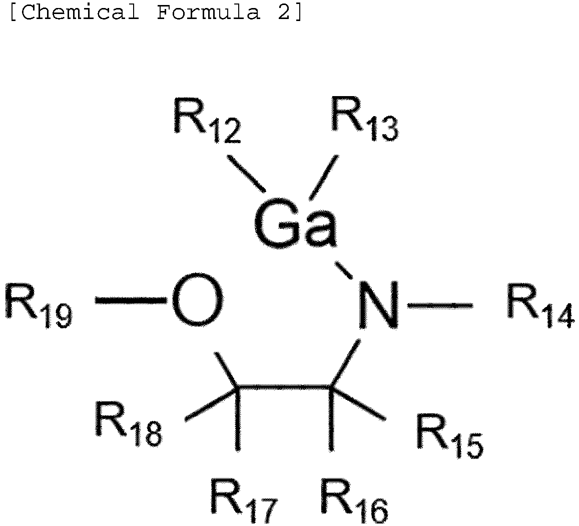

In Chemical Formula 2,
R₁₂ and R₁₃ are each independently hydrogen, a linear or branched hydrocarbon group having 1 to 4 carbon atoms, OR₂₀, or NR₂₁R₂₂,
R₁₄ and R₁₉ are each independently hydrogen or a linear or branched hydrocarbon group having 1 to 6 carbon atoms,
R₁₅ to R₁₈ are each independently hydrogen or a linear or branched hydrocarbon group having 1 to 3 carbon atoms, and
R₂₀ to R₂₂ are each independently hydrogen or a linear or branched hydrocarbon group having 1 to 3 carbon atoms.

In an embodiment of the present disclosure, preferably, R₁, R₂, R₁₂, and R₁₃ may each independently be any one selected from the group consisting of hydrogen, a methyl group, an ethyl group, an n-propyl group, an iso-propyl group, an n-butyl group, an iso-butyl group, a sec-butyl group, a tert-butyl group, an OH group, an OMe group, an OEt group, an OⁿPr group, an OⁱPr group, an NH₂ group, an NHMe group, an NHEt group, an NHⁿPr group, an NHⁱPr group, an NMe₂ group, an NMeEt group, an NMeⁿPr group, an NMeⁱPr group, an NEt₂ group, an NEtⁿPr group, an NEtⁱPr group, an NⁿPr₂ group, an NⁿPrⁱPr group, and an NⁱPr₂ group. Me is methyl, Et is ethyl, ⁿPr is n-propyl, and ⁱPr is iso-propyl.

More preferably, R₁, R₂, R₁₂, and R₁₃ may each independently be any one selected from the group consisting of hydrogen, a methyl group, an ethyl group, an n-propyl group, and an iso-propyl group, but are not limited thereto.

More preferably, R₁, R₂, R₁₂, and R₁₃ may be methyl groups.

In an embodiment of the present disclosure, preferably, R₃, R₈, R₁₄, and R₁₉ may each independently be any one selected from the group consisting of hydrogen, a methyl group, an ethyl group, an n-propyl group, an iso-propyl group, an n-butyl group, an iso-butyl group, a sec-butyl group, a tert-butyl group, an n-pentyl group, an iso-pentyl group, a neo-pentyl group, a sec-pentyl group, a tert-pentyl group, a hexyl group, an iso-hexyl group, and isomers thereof.

More preferably, R₃, R₈, R₁₄, and R₁₉ may be any one selected from the group consisting of hydrogen, a methyl group, an ethyl group, an n-propyl group, an iso-propyl group, an n-butyl group, an iso-butyl group, a sec-butyl group, and a tert-butyl group, but are not limited thereto.

More preferably, R₃ and R₁₄ may be tert-butyl groups, and R₈ and R₁₉ may be methyl groups.

In an embodiment of the present disclosure, preferably, R₄ to R₇ and R₁₅ to R₁₈ may each independently be any one selected from the group consisting of hydrogen, a methyl group, an ethyl group, an n-propyl group, and an iso-propyl group.

More preferably, R₄ to R₇ and R₁₅ to R₁₈ may each independently be any one selected from the group consisting of hydrogen, a methyl group, and an ethyl group, but are not limited thereto.

More preferably, R₄, R₅, R₁₅, and R₁₆ may be hydrogen, and R₆, R₇, R₁₇, and R₁₈ may be methyl groups.

In an embodiment of the present disclosure, preferably, R₉ to R₁₁ and R₂₀ to R₂₂ may each independently be any one selected from the group consisting of hydrogen, a methyl group, an ethyl group, an n-propyl group, and an iso-propyl group.

In an embodiment of the present disclosure, a molar ratio of the first compound to the second compound included in the composition may be 1:1 to 5:1.

For example, the molar ratio of the first compound to the second compound may be 1:1 to 5:1, 1.5:1 to 4.5:1, 1.8:1 to 4.2:1, or 2:1 to 4:1.

When the molar ratio of the first compound to the second compound is outside the range of the present disclosure, it may be difficult to form a thin film having a desired atomic ratio when the thin film is deposited.

In an embodiment of the present disclosure, the composition including the first compound and the second compound may be liquid at room temperature. In addition, the composition has a low melting point, and has excellent volatility at a low temperature.

A precursor composition for vapor deposition according to an aspect of the present disclosure may include any one of the compositions.

A method for manufacturing a thin film according to an aspect of the present disclosure may include introducing the precursor composition for vapor deposition into a chamber.

In an embodiment of the present disclosure, the introducing of the precursor composition for vapor deposition into the chamber may include performing physical adsorption, chemical adsorption, or physical and chemical adsorption.

In an embodiment of the present disclosure, the method for manufacturing the thin film may include both Atomic Layer Deposition (ALD) and Chemical Vapor Deposition (CVD).

More specifically, the deposition method may include Metal Organic Chemical Vapor Deposition (MOCVD), Low Pressure Chemical Vapor Deposition (LPCVD), Pulsed Chemical Vapor Deposition (P-CVD), Plasma Enhanced Atomic Layer Deposition (PE-ALD), or a combination thereof.

Preferably, the method for manufacturing the thin film may be Atomic Layer Deposition, but is not limited thereto.

In Atomic Layer Deposition (ALD), a reactant is required to have high volatility, material stability, and high reactivity. In Atomic Layer Deposition (ALD), reaction raw materials are separately supplied, so that a thin film of a monolayer or less is grown by a surface reaction during deposition of one cycle. Furthermore, a ligand of a reaction raw material adsorbed on a substrate is removed through a chemical reaction with another reaction raw material subsequently supplied. When the precursor composition, which is a reactant, is heated for Atomic Layer Deposition, a liquid phase may be much more advantageous than a solid phase in terms of reaction rate and process.

In an embodiment of the present disclosure, the method for manufacturing the thin film may further include injecting, as a reaction gas, a compound (or mixture) including oxygen (O) atoms.

Specifically, an oxide thin film may be deposited using, as the reaction gas, at least one selected from water vapor (H₂O), hydrogen peroxide vapor (H₂O₂), oxygen (O₂), a mixture of oxygen and hydrogen (O₂+H₂), and ozone (O₃), but the reaction gas is not limited thereto.

In an embodiment of the present disclosure, when the method for manufacturing the thin film is Atomic Layer Deposition (ALD), the method may include a first purge process of purging the precursor composition from the chamber before the injecting of the reaction gas, and/or a second purge process of purging a byproduct that does not react with the precursor composition or that is generated by reacting with the precursor composition after the injecting of the reaction gas.

In the purge process, movement of the precursor on the substrate is assisted, the inside of a reactor is allowed to have pressure appropriate for deposition, and impurities and so on present in the reactor are discharged to the outside. That is, a process of purging an inert gas, such as argon (Ar), nitrogen (N₂), or helium (He), into the reactor may be additionally performed before and after supply of the reaction gas.

In an embodiment of the present disclosure, the method for manufacturing the thin film may have a process temperature of 50 degrees Celsius or more and 500 degrees Celsius or less.

For example, the process temperature may be 60 degrees Celsius or more and 480 degrees Celsius or less, 70 degrees Celsius or more and 460 degrees Celsius or less, 80 degrees Celsius or more and 440 degrees Celsius or less, 90 degrees Celsius or more and 350 degrees Celsius or less, 90 degrees Celsius or more and 315 degrees Celsius or less, 95 degrees Celsius or more and 310 degrees Celsius or less, or 100 degrees Celsius or more and 310 degrees Celsius or less.

When the process temperature is below the range of the present disclosure, a reaction rate may not be sufficient, and deposition may not be properly performed as a deposition rate becomes slow. When the process temperature exceeds the range of the present disclosure, the reaction rate may be too fast, impurities may be generated, or the precursor or the reaction gas may be decomposed, so that deposition may not be properly performed and formation of the thin film may be difficult to be performed.

In an embodiment of the present disclosure, when the method for manufacturing the thin film of the present disclosure in which the precursor composition for vapor deposition is introduced into the chamber is used, a section (ALD window) in which a deposition rate is constant regardless of the process temperature may appear at 95 degrees Celsius or more and 315 degrees Celsius or less.

For example, the ALD window may be 95 degrees Celsius or more and 310 degrees Celsius or less, 100 degrees Celsius or more and 315 degrees Celsius or less, or 100 degrees Celsius or more and 310 degrees Celsius or less.

In an embodiment of the present disclosure, when the thin film is deposited by the method for manufacturing the thin film of the present disclosure in a process temperature range of 90 degrees Celsius or more and 400 degrees Celsius or less, the deposition rate may be 0.7 Å/cycle or more and 1.4 Å/cycle or less.

For example, in a process temperature range of 95 degrees Celsius or more and 315 degrees Celsius or less, the thin film deposition rate according to the method for manufacturing the thin film of the present disclosure may be 0.7 Å/cycle or more and 1.00 Å/cycle or less, 0.7 Å/cycle or more and 0.95 Å/cycle or less, 0.73 Å/cycle or more and 0.95 Å/cycle or less, 0.75 Å/cycle or more and 0.96 Å/cycle or less, or 0.75 Å/cycle or more and 0.95 Å/cycle or less.

In an embodiment of the present disclosure, the method for manufacturing the thin film may have a canister temperature of 30 degrees Celsius or more and 100 degrees Celsius or less.

For example, the canister temperature may be 35 degrees Celsius or more and 95 degrees Celsius or less, 40 degrees Celsius or more and 90 degrees Celsius or less, 45 degrees Celsius or more and 85 degrees Celsius or less, 50 degrees Celsius or more and 80 degrees Celsius or less, 55 degrees Celsius or more and 75 degrees Celsius or less, 60 degrees Celsius or more and 70 degrees Celsius or less, 30 degrees Celsius, 40 degrees Celsius, 50 degrees Celsius, 60 degrees Celsius, 70 degrees Celsius, 80 degrees Celsius, 90 degrees Celsius, or 100 degrees Celsius. Preferably, the canister temperature may be 65 degrees Celsius.

The canister is used to supply source gas into the chamber for reaction in the method for manufacturing the thin film. Typically, the canister vaporizes the precursor composition to generate source gas and then supplies the source gas into the chamber.

When the canister temperature is less than 30 degrees Celsius or exceeds 100 degrees Celsius, uniformity of thickness of the thin film manufactured through the method for manufacturing the thin film may be greatly reduced. This is because, at less than 30 degrees Celsius, a supply amount of the precursor composition to the chamber is not sufficient and, at more than 100 degrees Celsius, a uniform film quality may be difficult to be acquired due to decomposition of the precursor composition by thermal energy or an excessive supply amount of the precursor composition to the chamber.

In an embodiment of the present disclosure, an injection time of the precursor composition may be 1 second or more and 30 seconds or less, and an injection amount of precursor composition carrier gas may be 10 sccm or more and 1000 sccm or less.

For example, the precursor composition injection time may be 1 second or more and 27 seconds or less, 2 seconds or more and 24 seconds or less, 3 seconds or more and 15 seconds or less, or 3 seconds or more and 12 seconds or less, and
an injection amount of purge gas in the first purge process may be 20 sccm or more and 800 sccm or less, 40 sccm or more and 700 sccm or less, 60 sccm or more and 600 sccm or less, 80 sccm or more and 500 sccm or less, 100 sccm or more and 450 sccm or less, 150 sccm or more and 400 sccm or less, or 250 sccm or more and 350 sccm or less.

When the process is performed outside the above-described ranges, formation of an appropriate thin film may be difficult to be realized.

Specifically, when the injection time of the precursor composition is below the range of the present disclosure, a reactant necessary for forming the thin film may be insufficient, so that a thin film having an appropriate thickness may not be formed. In contrast, when the injection time of the precursor composition exceeds the range of the present disclosure, a composition ratio of the manufactured thin film may become non-uniform due to impurities caused by a remaining compound after reaction.

In addition, when the injection amount of the precursor composition carrier gas is below the range of the present disclosure, a remaining amount of the precursor composition which is a reactant may increase and an inappropriate reaction may occur, and impurities may not be purged, so that a thin film layer may be deposited non-uniformly.

In an embodiment of the present disclosure, an injection time of the reaction gas may be 1 second or more and 30 seconds or less, and an injection amount of the reaction gas may be 50 sccm or more and 3000 sccm or less.

For example, the injection time of the reaction gas may be 2 seconds or more and 27 seconds or less, 3 seconds or more and 24 seconds or less, 4 seconds or more and 21 seconds or less, 5 seconds or more and 19 seconds or less, 6 seconds or more and 17 seconds or less, 7 seconds or more and 15 seconds or less, or 5 seconds or more and 15 seconds or less.

In addition, the reaction gas injection amount may be, for example, 100 sccm or more and 2500 sccm or less, 300 sccm or more and 2000 sccm or less, 500 sccm or more and 1500 sccm or less, 700 sccm or more and 1300 sccm or less, or 900 sccm or more and 1100 sccm or less.

In addition, when the injection amount of the reaction gas is less than 50 sccm, the remaining amount of the precursor composition which is a reactant may increase and an inappropriate reaction may occur, and impurities may be generated, so that the thin film layer may be deposited non-uniformly. In contrast, when the injection amount of the reaction gas exceeds 3000 sccm, impurities may be generated by a reaction gas compound.

In an embodiment of the present disclosure, a purge gas injection time may be 1 second or more and 1 minute or less, and a purge gas injection amount may be 100 sccm or more and 4000 sccm or less.

For example, a purge gas injection time in the first purge process may be 2 seconds or more and 55 seconds or less, 3 seconds or more and 50 seconds or less, 4 seconds or more and 45 seconds or less, 5 seconds or more and 40 seconds or less, 6 seconds or more and 35 seconds or less, 7 seconds or more and 28 seconds or less, 8 seconds or more and 21 seconds or less, or 9 seconds or more and 15 seconds or less, and
the purge gas injection amount may each independently be 100 sccm or more and 200 sccm or less, 100 sccm or more and 400 sccm or less, 100 sccm or more and 600 sccm or less, 100 sccm or more and 800 sccm or less, 100 sccm or more and 1000 sccm or less, 100 sccm or more and 1400 sccm or less, 100 sccm or more and 1800 sccm or less, 100 sccm or more and 2200 sccm or less, 100 sccm or more and 3600 sccm or less, 100 sccm or more and 3000 sccm or less, 100 sccm or more and 3300 sccm or less, 100 sccm or more and 3600 sccm or less, 100 sccm or more and 3900 sccm or less, 200 sccm or more and 3500 sccm or less, 300 sccm or more and 3000 sccm or less, 400 sccm or more and 2500 sccm or less, 500 sccm or more and 2400 sccm or less, 600 sccm or more and 1300 sccm or less, 700 sccm or more and 2200 sccm or less, 800 sccm or more and 2100 sccm or less, 900 sccm or more and 2000 sccm or less, 1000 sccm or more and 1900 sccm or less, 1100 sccm or more and 1800 sccm or less, 1200 sccm or more and 1700 sccm or less, or 1300 sccm or more and 1600 sccm or less.

In an embodiment of the present disclosure, the number of repetitions of the cycle may be 10 or more.

For example, the number of repetitions of the cycle may be 10 or more, 100 or more, 200 or more, 500 or more, 1,000 or more, 5,000 or more, 10,000 or more, 50,000 or more, or 100,000 or more and 1,000,000 or less.

When the process conditions for the reaction gas, the process temperature, the precursor composition, and the purge gas described above are not satisfied, a thin film having excellent characteristics cannot be acquired.

A thin film according to an aspect of the present disclosure may be manufactured by the method for manufacturing the thin film.

In an embodiment of the present disclosure, a refractive index (RI) of the thin film may be 1.75 to 2.20. For example, the refractive index may be 1.85 to 2.15 or 1.95 to 2.10.

In an embodiment of the present disclosure, an atomic percentage ratio (x:y) of indium to gallium in the thin film (InₓGa_{y}O_{z}) analyzed by X-Ray Photoelectron Spectroscopy (XPS) may be 1:1 to 5:1. For example, the atomic percentage ratio of indium to gallium may be 1:1 to 5:1, 1.5:1 to 4.5:1, 1.8:1 to 4.2:1, or 2:1 to 4:1. That is, the atomic percentage ratio of indium to gallium in the indium gallium oxide thin film may be the same as the molar ratio of the first compound to the second compound.

In an embodiment of the present disclosure, an indium (In) content of the thin film analyzed by X-Ray Photoelectron Spectroscopy (XPS) may be 25 atomic% or more and 40 atomic% or less, a gallium (Ga) content may be 7 atomic% or more and 20 atomic% or less, and an oxygen (O) content may be 50 atomic% or more and 60 atomic% or less.

In an embodiment of the present disclosure, as a result of analyzing the thin film by X-Ray Diffractometry (XRD), a broad peak, a (211) peak, a (222) peak, a (431) peak, a (440) peak, a (622) peak, or the like may appear.

In an embodiment of the present disclosure, a phase of the thin film analyzed by X-Ray Diffractometry (XRD) may be nanocrystalline or polycrystalline.

In an embodiment of the present disclosure, a density of the thin film analyzed by X-Ray Reflectometry (XRR) may be 6.0 g/cm³ or more. For example, the density may be 6.1 g/cm³ or more, 6.2 g/cm³ or more, 6.3 g/cm³ or more, or 6.4 g/cm³ or more.

In addition, the density of the thin film may be 7.0 g/cm³ or less. For example, the density may be 6.95 g/cm³ or less.

A roughness of the thin film may be 5 Å or more and 9.5 Å or less. For example, the roughness may be 5.6 Å or more and 9.2 Å or less, 5.6 Å or more and 7.5 Å or less, or 5.6 Å or more and 7.0 Å or less. The thin film may have excellent interface characteristics and corrosion resistance due to surface characteristics and density of the thin film.

### Mode for Invention

Hereinafter, the present disclosure will be described in more detail through examples. However, the following examples are provided to describe the present disclosure more specifically, and the scope of the present disclosure is not limited by the following examples.

### [Synthesis Example]

### Synthesis Example 1: Synthesis of dimethylchloroindium (In(CH₃)₂Cl)

Trimethyl indium and pentane were added to a Schlenk flask, and trichloroindium was slowly added to the resulting solution cooled to -20°C, followed by stirring for 30 minutes. Thereafter, temperature was gradually increased, and stirring was performed at room temperature to obtain dimethylchloroindium (In(CH₃)₂Cl).

A synthesis method of dimethylchloroindium (In(CH₃)₂Cl) is shown in the following Scheme 1.

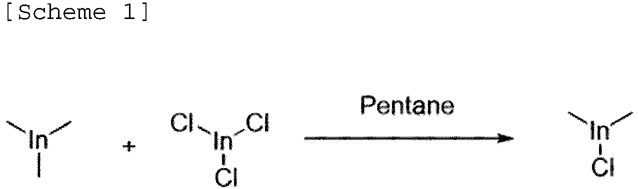

### Synthesis Example 2: Synthesis of dimethylchlorogallium (Ga(CH₃)₂Cl)

Trimethyl gallium and pentane were added to a Schlenk flask, and trichlorogallium was slowly added to the resulting solution cooled to -20°C, followed by stirring for 30 minutes. Thereafter, temperature was gradually increased, and stirring was performed at room temperature to obtain dimethylchlorogallium (Ga(CH₃)₂Cl).

A synthesis method of dimethylchlorogallium (Ga(CH₃)₂Cl) is shown in the following Scheme 2.

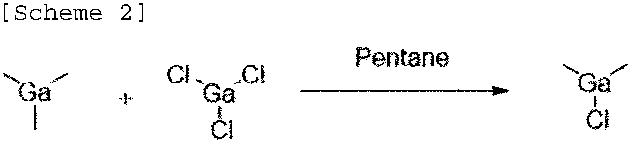

### Synthesis Example 3: Synthesis of In(CH₃)₂[CH₃OC(CH₃)₂CH₂NBu](DMION) precursor compound

After n-butyllithium (n-butyl lithium, 2.5 M in hexane) was added to a Schlenk flask, a ligand [CH₃OC(CH₃)₂CH₂NH^{t}Bu] diluted in pentane or hexane was slowly added to the reaction mixture cooled to -20 degrees Celsius. After the ligand was completely added, temperature of the reaction mixture was gradually increased, and the reaction mixture was stirred at room temperature for 1 hour to prepare a solution. The solution was slowly added to dimethylchloroindium (Synthesis Example 1), and then then temperature of the flask was gradually increased, followed by stirring at room temperature for 18 hours. Then, a solid in the solution was filtered out, a solvent was removed using vacuum to obtain a light yellow liquid, and the obtained liquid was vacuum-distilled to obtain an In (CH₃)₂[CH₃OC(CH₃)₂CH₂N^{t}Bu] precursor compound from which impurities were removed.

The synthesized In(CH₃)₂[CH₃OC(CH₃)₂CH₂N^{t}Bu] precursor compound is a compound in a transparent liquid state.

A synthesis method of the synthesized In (CH₃)₂[CH₃OC(CH₃)₂CH₂N^{t}Bu] precursor compound is shown in the following Scheme 3.

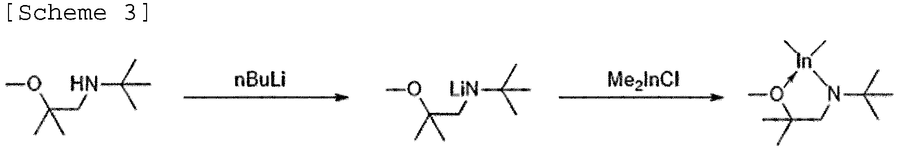

NMR measurement results of the synthesized In(CH₃)₂[CH₃OC(CH₃)₂CH₂N^{t}Bu] precursor compound are as follows.

¹H-NMR (C₆D₆):
δ 2.93 In(CH₃)₂[CH₃OC(CH₃)₂CH₂N^{t}Bu], s, 2H)
δ 2.62 In(CH₃)₂[CH₃OC(CH₃)₂CH₂N^{t}Bu], s, 3H)
δ 1.26 In(CH₃)₂[CH₃OC(CH₃)₂CH₂N^{t}Bu], s, 9H)
δ 0.97 In(CH₃)₂[CH₃OC(CH₃)₂CH₂N^{t}Bu], s, 6H)
δ 0.04 In(CH₃)₂[CH₃OC(CH₃)₂CH₂N^{t}Bu], s, 6H)

### Synthesis Example 4: Synthesis of Ga(CH₃)₂[CH₃OC(CH₃)₂CH₂N^{t}Bu] (DMGON) precursor compound

After n-butyllithium (n-butyl lithium, 2.5 M in hexane) was added to a Schlenk flask, a ligand [CH₃OC(CH₃)₂CH₂NH^{t}Bu] diluted in pentane or hexane was slowly added to the reaction mixture cooled to -20 degrees Celsius. After the ligand was completely added, temperature of the flask was gradually increased, and a solution stirred at room temperature for 1 hour was prepared. The solution was slowly added to dimethylchlorogallium (Synthesis Example 2), and then temperature of the flask was gradually increased, followed by stirring at room temperature for 18 hours. Thereafter, a solid in the solution was filtered out, a solvent was removed using vacuum to obtain a light yellow liquid, and the obtained liquid was vacuum-distilled to obtain a Ga (CH₃)₂[CH₃OC(CH₃)₂CH₂N^{t}Bu] precursor compound from which impurities were removed.

The synthesized Ga (CH₃)₂[CH₃OC(CH₃)₂CH₂N^{t}Bu] precursor compound is a compound in a transparent liquid state.

A synthesis method of the Ga(CH₃)₂[CH₃OC(CH₃)₂CH₂N^{t}Bu] precursor compound is shown in the following Scheme 4.

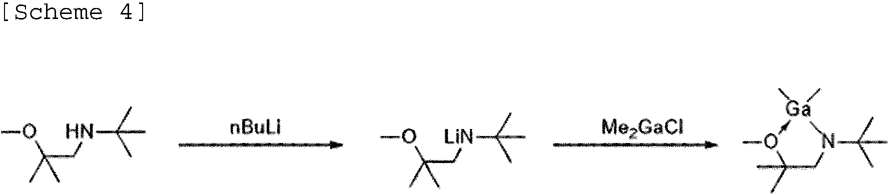

NMR measurement results of the synthesized Ga(CH₃)₂[CH₃OC(CH₃)₂CH₂N^{t}Bu] precursor compound are as follows.

¹H-NMR (C₆D₆) :
δ 2.82 Ga(CH₃)₂[CH₃OC(CH₃)₂CH₂N^{t}Bu], s, 2H)
δ 2.62 Ga(CH₃)₂CH₃OC(CH₃)₂CH₂N^{t}Bu s, 3H)
δ 1.28 Ga(CH₃)₂CH₃OC(CH₃)₂CH₂N^{t}Bu s, 9H)
δ 0.93 Ga(CH₃)₂[CH₃OC(CH₃)₂CH₂N^{t}Bu], s, 6H)
δ -0.04 Ga(CH₃)₂[CH₃OC(CH₃)₂CH₂N^{t}Bu s, 6H)

### [Example]

### Example: Preparation of Composition

A composition of the example was prepared by mixing an In(CH₃)₂[CH₃OC(CH₃)₂CH₂N^{t}Bu] precursor compound (Synthesis Example 3, DMION) and a Ga(CH₃)₂[CH₃OC(CH₃)₂CH₂N^{t}Bu] precursor compound (Synthesis Example 4, DMGON) at a molar ratio of 3:1.

### [Preparation Example]

### Preparation Examples 1 to 3: Manufacture of Indium Gallium Oxide Film Using Atomic Layer Deposition (ALD)

An indium gallium oxide thin film (InₓGa_{y}O_{z}) was manufactured through Atomic Layer Deposition (ALD) using the composition (DMION:DMGON=3:1) of the example.

A substrate used in the present experiment was a borondoped p-type silicon wafer having a silicon oxide film having a thickness of 100 nm deposited on a surface thereof. The silicon oxide film of the substrate was manufactured through a dry oxidation process.

Ozone (O₃) having a concentration of 200 g/m³ was used as a reaction gas, and was generated from oxygen gas of 1,000 sccm. Argon (Ar), which is an inert gas, was used to serve as a carrier of a precursor and to purge the precursor and the reaction gas, a flow rate of carrier argon was 300 sccm, and a flow rate of purge argon was 1,500 sccm.

### [Preparation Example 1]

(Injection of precursor for x seconds)-(injection of purge gas for 10 seconds)-(injection of reaction gas for 12 seconds)-(injection of purge gas for 10 seconds) were sequentially performed, and this was defined as one cycle.

In supplying the indium gallium mixed precursor composition of Preparation Example 1, the x seconds were set to 3 seconds to 12 seconds, a process temperature was set to 100 degrees Celsius or 310 degrees Celsius, and the number of cycles was set to 100 to deposit an indium gallium oxide film.

Specific process conditions are shown in Table 1 below.

**[Table 1]**

| Preparatio n Example | Precurso r injectio n time (sec) | Precurso r purge time (sec) | Reaction gas injectio n time (sec) | Reactio n gas purge time (sec) | Process temperat ure (°C) | Number of cycles (cycles ) |
|---|---|---|---|---|---|---|
| 1-1 | 3 | | | | 100 | |
| 1-2 | 5 | | | | | |
| 1-3 | 7 | | | | | |
| 1-4 | 10 | | | | | |
| 1-5 | 12 | 10 | 12 | 10 | | 100 |
| 1-6 | 3 | | | | 310 | |
| 1-7 | 5 | | | | | |
| 1-8 | 7 | | | | | |
| 1-9 | 10 | | | | | |
| 1-10 | 12 | | | | | |

In manufacturing the indium gallium oxide film of Preparation Example 1, a change in deposition rate according to a change in precursor injection time is shown in FIG. 1(a).

As shown in FIG. 1(a), at a process temperature of 100 degrees Celsius, as the precursor injection time increased from 3 seconds to 10 seconds, the deposition rate increased from 0.75 Å/cycle to 0.82 Å/cycle, and the deposition rate was constant after 10 seconds. Accordingly, a self-limited reaction, which is a characteristic of Atomic Layer Deposition (ALD), was confirmed.

In addition, as shown in FIG. 1(a), at a process temperature of 310 degrees Celsius, as the precursor injection time increased from 3 seconds to 10 seconds, the deposition rate increased from 0.79 Å/cycle to 0.92 Å/cycle, and the deposition rate was constant after 10 seconds. Accordingly, a self-limited reaction, which is a characteristic of Atomic Layer Deposition (ALD), was confirmed.

### [Preparation Example 2]

(Injection of precursor for 10 seconds)-(injection of purge gas for 10 seconds)-(injection of reaction gas for y seconds)-(injection of purge gas for 10 seconds) were sequentially performed, and this was defined as one cycle.

In supplying the reaction gas of Preparation Example 2, the y seconds were set to 5 seconds to 15 seconds, a process temperature was set to 100 degrees Celsius or 310 degrees Celsius, and the number of cycles was set to 100 to deposit an indium gallium oxide film.

Specific process conditions are shown in Table 2 below.

**[Table 2]**

| Preparatio n Example | Precurso r injectio n time (sec) | Precurso r purge time (sec) | Reaction gas injectio n time (sec) | Reactio n gas purge time (sec) | Process temperatur e (°C) | Number of cycle s (cycl es) |
|---|---|---|---|---|---|---|
| 2-1 | 10 | 10 | 5 | 10 | 100 | 100 |
| 2-2 | | | 7 | | | |
| 2-3 | | | 10 | | | |
| 2-4 | | | 12 | | | |
| 2-5 | | | 15 | | | |
| 2-6 | | | 5 | | 310 | |
| 2-7 | | | 7 | | | |
| 2-8 | | | 10 | | | |
| 2-9 | | | 12 | | | |
| 2-10 | | | 15 | | | |

In manufacturing the indium gallium oxide film of Preparation Example 2, a change in deposition rate according to a change in reaction gas injection time is shown in FIG. 1(b).

As shown in FIG. 1(b), at a process temperature of 100 degrees Celsius, as the reaction gas injection time increased from 5 seconds to 7 seconds, the deposition rate increased from 0.79 Å/cycle to 0.81 Å/cycle, and the deposition rate was constant after 7 seconds. Accordingly, a self-limited reaction, which is a characteristic of Atomic Layer Deposition (ALD), was confirmed.

In addition, as shown in FIG. 1(b), at a process temperature of 310 degrees Celsius, the deposition rate was constant at 0.92 Å/cycle from a reaction gas injection time of 3 seconds. Accordingly, a self-limited reaction, which is a characteristic of Atomic Layer Deposition (ALD), was confirmed.

### [Preparation Example 3]

(Injection of precursor for 10 seconds)-(injection of purge gas for 10 seconds)-(injection of reaction gas for 12 seconds)-(injection of purge gas for 10 seconds) were sequentially performed, and this was defined as one cycle.

The process temperature of Preparation Example 3 was set to 100 degrees Celsius to 400 degrees Celsius, and the number of cycles was set to 100 to deposit an indium gallium oxide film.

Specific process conditions are shown in Table 3 below.

**[Table 3]**

| Preparatio n Example | Precurso r injectio n time (sec) | Precurso r purge time (sec) | Reaction gas injectio n time (sec) | Reactio n gas purge time (sec) | Process temperatur e (°C) | Number of cycle s (cycl es) |
|---|---|---|---|---|---|---|
| 3-1 | | | | | 100 | |
| 3-2 | | | | | 130 | |
| 3-3 | | | | | 160 | |
| 3-4 | | | | | 190 | |
| 3-5 | 10 | 10 | 12 | 10 | 220 | 100 |
| 3-6 | | | | | 250 | |
| 3-7 | | | | | 280 | |
| 3-8 | | | | | 310 | |
| 3-9 | | | | | 340 | |
| 3-10 | | | | | 370 | |
| 3-11 | | | | | 400 | |

In manufacturing the indium gallium oxide film of Preparation Example 3, a change in deposition rate according to a change in process temperature is shown in FIG. 1(c).

As shown in FIG. 1(c), the deposition rate was constantly maintained at 0.75 Å/cycle to 0.91 Å/cycle at a process temperature of 100 degrees Celsius to 310 degrees Celsius. Accordingly, an ALD window (that is a section in which the deposition rate is constant regardless of the process temperature) when the composition of the example is used was confirmed to be 100 degrees Celsius to 310 degrees Celsius. As the process temperature increased from 340 degrees Celsius to 400 degrees Celsius, the deposition rate significantly increased from 1.09 Å/cycle to 1.33 Å/cycle.

It was confirmed that the refractive index was maintained at 2.04 regardless of the process temperature.

### [Evaluation Example]

### Evaluation Example 1: NMR Measurement

¹H NMR of the composition having a DMION-to-DMGON ratio of 3:1 according to the example was measured using Varian 400 MHz.

As shown in FIG. 2, as a result of NMR measurement of the composition of the example, it was confirmed that a ratio of a methyl H peak δ -0.06 (s, 6H) of In to a methyl H peak δ -0.16 (s, 6H) of Ga was 3:1, which was the same as a molar ratio of the compound of Synthesis Example 3 to the compound of Synthesis Example 4.

### Evaluation Example 2: Thermogravimetric Analysis (TGA)

Thermogravimetric analysis was performed on the composition having the DMION-to-DMGON ratio of 3:1 according to the example using a TG209 F1 Libra instrument manufactured by Netzsch.

An alumina crucible having a capacity of 50 µL was used, an amount of each sample was 10 mg, and measurement was performed by increasing temperature from 30 degrees Celsius to 500 degrees Celsius at a rate of 10 °C/min.

TGA measurement results of the composition having the DMION-to-DMGON ratio of 3:1 according to the example are shown in FIG. 3.

As a result of thermogravimetric analysis, as shown in FIG. 3, a half-life temperature (T_{1/2}, °C) of the composition having the DMION-to-DMGON ratio of 3:1 according to the example was 132.6 degrees Celsius. In addition, it was confirmed that a residual amount of the composition having the DMION-to-DMGON ratio of 3:1 according to the example at 200 degrees Celsius was 2.8 wt%, and a residual amount at 300 degrees Celsius was 2.7 wt%.

### Evaluation Example 3: Composition Analysis of Oxide Film

Composition and impurity content of an indium gallium oxide film deposited using the composition having the DMION-to-DMGON ratio of 3:1 according to the example were analyzed through X-ray Photoelectron Spectroscopy (XPS).

XPS depth profile measurement results of an indium gallium oxide film which has a thickness of 20 nm and which is deposited at a process temperature of 310 degrees Celsius are shown in FIG. 4.

As shown in FIG. 4, as a result of XPS depth profile measurement, indium (In) was 31.0 atomic%, gallium (Ga) was 11.8 atomic%, and oxygen (O) was 57.2 atomic%, whereas impurities such as carbon, nitrogen, and hydrogen were not detected, and a ratio of oxygen to metal was 1.34.

That is, it was confirmed that a ratio of indium atoms to gallium atoms included in the indium gallium oxide film manufactured in an ALD window followed a mixing ratio of the indium precursor compound (Synthesis Example 3) to the gallium precursor compound (Synthesis Example 4) of the composition. In addition, it was confirmed that impurities, such as carbon, nitrogen, and hydrogen, included in the indium gallium oxide film were at negligible levels.

### Evaluation Example 4: Analysis of Crystallinity and Density of Oxide Film

Crystallinity and density of an indium gallium oxide film deposited using the composition having the DMION-to-DMGON ratio of 3:1 according to the example were analyzed through X-Ray Diffractometry (XRD) and X-Ray Reflectometry (XRR).

XRD analysis results of indium gallium oxide films deposited using the composition having the DMION-to-DMGON ratio of 3:1 according to the example at process temperatures of 100 degrees Celsius and 310 degrees Celsius are shown in FIG. 5.

At a process temperature of 100 degrees Celsius, a broad peak appeared and, accordingly, it was found that a microstructure of the oxide film was nanocrystalline close to amorphous. In addition, at a process temperature of 310 degrees Celsius, several sharp peaks, such as a (211) peak, a (222) peak, a (431) peak, a (440) peak, and a (622) peak, appeared and, accordingly, it was found that a microstructure of the oxide film was polycrystalline. As a result of confirmation of the polycrystalline oxide film with reference to ICDD card (00-006-0316), it was confirmed that the polycrystalline oxide film had an Ia-3 space group of a cubic crystal system.

XRR analysis results of indium gallium oxide films deposited using the composition having the DMION-to-DMGON ratio of 3:1 according to the example at process temperatures of 100 degrees Celsius and 310 degrees Celsius are shown in FIG. 6.

As shown in FIG. 6, it was confirmed that density of the oxide film deposited at the process temperature of 100 degrees Celsius was 6.45 g/cm³, and density of the oxide film deposited at the process temperature of 310 degrees Celsius was 6.91 g/cm³. In addition, it was confirmed that roughness of the oxide film deposited at the process temperature of 100 degrees Celsius was 6.70 Å, and roughness of the oxide film deposited at the process temperature of 310 degrees Celsius was 5.80 Å.

That is, it was confirmed that, as the process temperature increased, crystallinity of the thin film increased and compactness also increased together, thereby ultimately increasing density of the thin film.

### Evaluation Example 5: Analysis of Step Coverage of Oxide Film

Step coverage of an indium gallium oxide film deposited using the composition having the DMION-to-DMGON ratio of 3:1 according to the example was analyzed through Transmission Electron Microscope (TEM) observation and Energy Dispersive X-Ray Spectrometry (EDS).

FIG. 7(a) shows a TEM photograph of an indium gallium oxide film deposited at a process temperature of 310 degrees Celsius and manufactured in a trench structure having an aspect ratio of 40:1.

As shown in FIG. 7(a), it was confirmed that the indium gallium oxide film deposited using the composition of the example had excellent step coverage.

FIG. 7(b) shows EDS mapping results of the indium gallium oxide film.

As shown in FIG. 7(b), it was confirmed that indium atoms and gallium atoms were uniformly distributed in the indium gallium oxide film deposited using the composition having the DMION-to-DMGON ratio of 3:1 according to the example.

As described above, it was confirmed that the composition of the present disclosure had excellent ALD characteristics, that the ratio of indium atoms to gallium atoms in the indium gallium oxide film in the ALD window was consistent with the mixing ratio of the indium precursor compound to the gallium precursor compound of the composition, and that impurities were hardly present in the thin film. In addition, it was confirmed that excellent step coverage was achieved even in the trench structure having an aspect ratio of 40:1.

Due to these excellent characteristics, a thin film deposited using the composition of the present disclosure is expected to be utilized as an active layer of an oxide thin film transistor (TFT) in a display device in the future, and may be used as a channel or the like in manufacturing a memory semiconductor.

The scope of the present disclosure is indicated by the following claims rather than the above detailed description, and all changes or modifications derived from the meaning and scope of the claims and their equivalents should be interpreted as being included in the scope of the present disclosure.

### Industrial Applicability

The composition according to the present disclosure is liquid, has excellent ALD characteristics, enables uniform thin film deposition, and accordingly enables securing of a thin film in which impurities are hardly present and which has excellent step coverage characteristics.

The above-described physical properties provide a precursor suitable for Atomic Layer Deposition and Chemical Vapor Deposition.

In addition, a thin film deposited using the composition of the present disclosure is expected to be utilized as an active layer of an oxide thin film transistor (TFT) in a display device in the future, and may be used as a channel or the like in manufacturing a memory semiconductor.

## Claims

1. A composition comprising:
a first compound represented by Chemical Formula 1 below; and
a second compound represented by Chemical Formula 2 below, 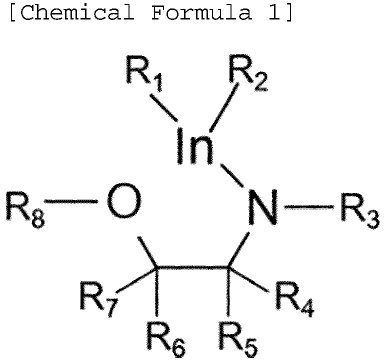 wherein, in Chemical Formula 1,
R₁ and R₂ are each independently hydrogen, a linear or branched hydrocarbon group having 1 to 4 carbon atoms, OR₉, or NR₁₀R₁₁,
R₃ and R₈ are each independently hydrogen or a linear or branched hydrocarbon group having 1 to 6 carbon atoms,
R₄ to R₇ are each independently hydrogen or a linear or branched hydrocarbon group having 1 to 3 carbon atoms, and
R₉ to R₁₁ are each independently hydrogen or a linear or branched hydrocarbon group having 1 to 3 carbon atoms, and 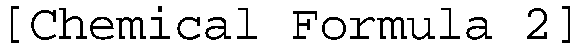 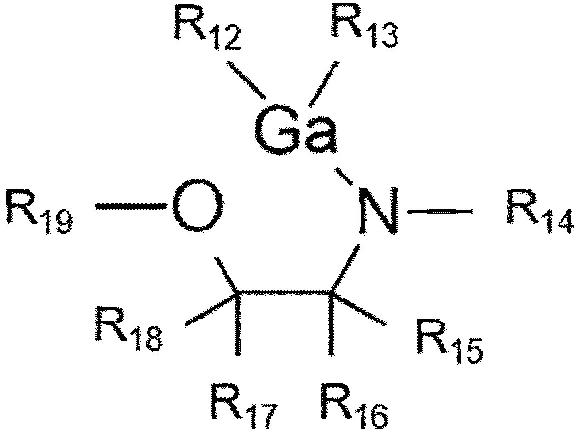 wherein, in Chemical Formula 2,
R₁₂ and R₁₃ are each independently hydrogen, a linear or branched hydrocarbon group having 1 to 4 carbon atoms, OR₂₀, or NR₂₁R₂₂,
R₁₄ and R₁₉ are each independently hydrogen or a linear or branched hydrocarbon group having 1 to 6 carbon atoms,
R₁₅ to R₁₈ are each independently hydrogen or a linear or branched hydrocarbon group having 1 to 3 carbon atoms, and
R₂₀ to R₂₂ are each independently hydrogen or a linear or branched hydrocarbon group having 1 to 3 carbon atoms.

2. The composition of claim 1, wherein R₁, R₂, R₁₂, and R₁₃ are each independently any one selected from the group consisting of hydrogen, a methyl group, an ethyl group, an n-propyl group, an iso-propyl group, an n-butyl group, an iso-butyl group, a sec-butyl group, a tert-butyl group, an OH group, an OMe group, an OEt group, an OⁿPr group, an OⁱPr group, an NH₂ group, an NHMe group, an NHEt group, an NHⁿPr group, an NHⁱPr group, an NMe₂ group, an NMeEt group, an NMeⁿPr group, an NMeⁱPr group, an NEt₂ group, an NEtⁿPr group, an NEtⁱPr group, an NⁿPr₂ group, an NⁿPrⁱPr group, and an NⁱPr₂ group, and wherein Me is methyl, Et is ethyl, ⁿPr is n-propyl, and ⁱPr is iso-propyl.

3. The composition of claim 1, wherein R₃, R₈, R₁₄, and R₁₉ are each independently any one selected from the group consisting of hydrogen, a methyl group, an ethyl group, an n-propyl group, an iso-propyl group, an n-butyl group, an iso-butyl group, a sec-butyl group, a tert-butyl group, an n-pentyl group, an iso-pentyl group, a neo-pentyl group, a sec-pentyl group, a tert-pentyl group, a hexyl group, an iso-hexyl group, and isomers thereof.

4. The composition of claim 1, wherein R₄ to R₇ and R₁₅ to R₁₈ are each independently any one selected from the group consisting of hydrogen, a methyl group, an ethyl group, an n-propyl group, and an iso-propyl group.

5. The composition of claim 1, wherein R₉ to R₁₁ and R₂₀ to R₂₂ are each independently any one selected from the group consisting of hydrogen, a methyl group, an ethyl group, an n-propyl group, and an iso-propyl group.

6. The composition of claim 1, wherein a molar ratio of the first precursor to the second precursor is 1:1 to 5:1.

7. A precursor composition for vapor deposition, the precursor composition comprising the composition according to any one of claim 1 to claim 6.

8. A method for manufacturing a thin film, the method comprising introducing the precursor composition for vapor deposition according to claim 7 into a chamber.

9. The method of claim 8, wherein the method comprises Atomic Layer Deposition (ALD) or Chemical Vapor Deposition (CVD).

10. The method of claim 8, further comprising:
injecting, as a reaction gas, a compound including oxygen (O) atoms,
wherein the reaction gas is at least one selected from water vapor (H₂O), hydrogen peroxide vapor (H₂O₂), oxygen (O₂), a mixture of oxygen and hydrogen (O₂+H₂), and ozone (O₃).

11. A thin film manufactured by the method of claim 8.
